# FASCICULE DE BREVET EUROPEEN

(11) **EP 4 136 420 B1**
(45) Date de publication et mention de la délivrance du brevet: **03.04.2024**
(21) Numéro de dépôt: 21718876.2
(22) Date de dépôt: 14.04.2021
(51) Int. Cl.: G01J 5/02, G01J 5/04

(54) **PROCEDE DE FABRICATION D'UN DISPOSITIF DE DETECTION COMPORTANT UNE PAROI PERIPHERIQUE EN UN MATERIAU MINERAL**
VERFAHREN ZUR HERSTELLUNG EINES SENSORS EINSCHLIESSLICH EINER PERIPHERIEWAND AUS EINEM MINERALISCHEN MATERIAL
METHOD FOR MANUFACTURING A DETECTION DEVICE INCLUDING A PERIPHERAL WALL IN A MINERAL MATERIAL

(30) Priorité: 16.04.2020 FR 2003858
(43) Date de publication de la demande: 22.02.2023
(73) Titulaire: Commissariat à l'énergie atomique et aux énergies alternatives, 75015 Paris (FR)
(72) Inventeur: DUMONT, Geoffroy, 38054 GRENOBLE cedex 09 (FR); YON, Jean-Jacques, 38054 GRENOBLE cedex 09 (FR)
(74) Mandataire: Brevalex
(86) Numéro de dépôt international: PCT/EP2021/059701
(87) Numéro de publication internationale: WO 2021/209518

(56) Documents cités:
- EP-A1- 3 637 071
- EP-A2- 3 067 674
- WO-A1-2014/100648

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques comportant chacun une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et isolées thermiquement de celui-ci par des bras de maintien et d'isolation thermique. Ces piliers d'ancrage et bras de maintien présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par ces derniers en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Au moins un plot de connexion électrique du circuit de lecture est disposé sur le substrat de telle manière qu'il puisse être contacté depuis l'extérieur du dispositif de détection.

Pour assurer un fonctionnement optimal des détecteurs thermiques, un faible niveau de pression peut être requis. Pour cela, la matrice de détecteurs thermiques est généralement confinée, ou encapsulée, dans une cavité hermétique sous vide ou à pression réduite, cette cavité étant délimitée, avec le substrat de lecture, par une structure d'encapsulation.

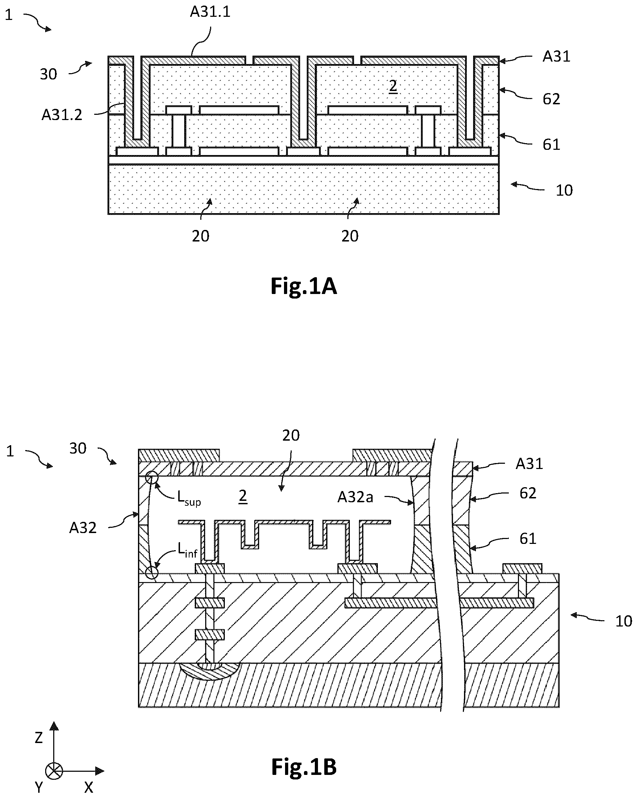

Le document EP3067674A2 décrit un exemple d'un procédé de fabrication d'un dispositif de détection 1, illustré ici sur la figure 1A, dont les détecteurs thermiques 20 sont disposés dans une cavité 2. Le procédé utilise des couches sacrificielles minérales 61, 62 (ici représentées avant leur suppression) pour réaliser les détecteurs thermiques 20 et la structure d'encapsulation 30 définissant la cavité 2, lesquelles sont ensuite supprimées par une gravure chimique humide. La structure d'encapsulation 30 est formée par une même couche mince A31 dite d'encapsulation qui s'étend continûment au-dessus et autour des détecteurs thermiques et délimite ainsi verticalement et latéralement la cavité 2. La couche mince d'encapsulation A31 est réalisée par dépôt conforme sur la face supérieure de la couche sacrificielle minérale 62, ainsi que dans une tranchée périphérique qui s'étend au travers des couches sacrificielles minérales 61, 62 jusqu'au substrat de lecture 10. Ainsi, la couche mince d'encapsulation A31 est formée d'une portion supérieure A31.1 qui repose initialement sur la couche sacrificielle minérale 62, ainsi que d'une portion périphérique A31.2 qui vient reposer sur le substrat de lecture 10 et entoure latéralement les détecteurs thermiques 20. Cette configuration permet notamment de réduire l'encombrement sur le substrat de lecture 10 de la structure d'encapsulation 30.

Le document WO2014/ 100648A1 décrit un autre exemple d'un procédé de fabrication d'un dispositif de détection 1, illustré ici sur la figure 1B, dont un détecteur thermique 20 est disposé dans une cavité 2. La structure d'encapsulation 30 est formée par une couche mince d'encapsulation A31 qui s'étend au-dessus du détecteur thermique 20, et par une paroi périphérique A32 qui entoure continûment le détecteur thermique 20 et sur laquelle la couche mince d'encapsulation A31 repose. La paroi périphérique A32 est formée par une portion non gravée des couches sacrificielles 61, 62. La paroi périphérique A32 présente une face latérale A3 2 a qui s'étend verticalement suivant l'axe Z. Autrement dit, la face latérale A3 2 a présente une extrémité supérieure Lₛᵤₚ au contact de la couche mince d'encapsulation A31 qui est située à la perpendiculaire de l'extrémité inférieure L_{inf} au contact du substrat de lecture 10.

Cependant, il existe un besoin de disposer d'un procédé de fabrication dont la tenue mécanique de la structure d'encapsulation est améliorée.

### EXPOSÉ DE L'INVENTION

L'invention a pour objectif de proposer un procédé de fabrication d'un dispositif de détection permettant d'améliorer la tenue mécanique de la structure d'encapsulation, limitant notamment les risques de décollement de la structure d'encapsulation en bordure de la cavité.

Pour cela, l'objet de l'invention est un procédé de fabrication d'un dispositif de détection d'un rayonnement électromagnétique, comportant les étapes suivantes :
- réalisation d'une matrice de détecteurs thermiques adaptés à détecter le rayonnement électromagnétique, sur un substrat de lecture, au travers d'une première couche sacrificielle minérale, les détecteurs thermiques et la première couche sacrificielle minérale étant recouverts par une deuxième couche sacrificielle minérale ;
- réalisation d'une structure d'encapsulation délimitant une cavité dans laquelle est située la matrice de détecteurs thermiques, la structure d'encapsulation étant formée d'une paroi périphérique et d'une couche mince d'encapsulation, par :
   ∘ dépôt de la couche mince d'encapsulation recouvrant la deuxième couche sacrificielle minérale ;
   ∘ réalisation d'évents dans la couche mince d'encapsulation et situés en regard de la matrice de détecteurs thermiques ;
   ∘ suppression partielle des couches sacrificielles minérales, par gravure chimique humide en milieu acide, au travers des évents, de manière à libérer la matrice de détecteurs thermiques et à obtenir la paroi périphérique formée d'une portion non gravée des couches sacrificielles minérales, et libérer une portion supérieure de la couche mince d'encapsulation s'étendant au-dessus de la matrice de détecteurs thermiques.

Selon l'invention, du fait que les couches sacrificielles sont minérales et que la suppression partielle est effectuée par gravure chimique humide en milieu acide, à la suite de l'étape de gravure chimique, la paroi périphérique présente un retrait latéral se traduisant par un élargissement vertical de la cavité, dans un plan parallèle au plan du substrat de lecture, entre le substrat de lecture et la portion supérieure, ce retrait latéral définissant une zone intermédiaire d'une surface du substrat de lecture entourant la matrice de détecteurs thermiques.

Le procédé de fabrication comporte alors une étape de réalisation de piliers de renfort de la couche mince d'encapsulation, agencés dans la zone intermédiaire autour de la matrice de détecteurs thermiques, distincts les uns des autres et s'étendant à partir de la portion supérieure jusqu'à reposer sur le substrat de lecture.

Certains aspects préférés, mais non limitatifs de ce procédé de fabrication sont les suivants.

La paroi périphérique peut présenter une face latérale délimitant latéralement la cavité, la face latérale s'étendant verticalement entre une extrémité inférieure au contact du substrat de lecture et une extrémité supérieure au contact de la portion supérieure, l'extrémité supérieure étant distante de l'extrémité inférieure, dans un plan parallèle au plan du substrat de lecture et suivant une direction opposée à la matrice de détecteurs thermiques, d'une distance supérieure ou égale à 10µm.

La portion supérieure de la couche mince d'encapsulation peut présenter une épaisseur inférieure ou égale à 800nm.

Les piliers de renfort peuvent être agencés en plusieurs lignes parallèles les unes aux autres, qui s'étendent autour de la matrice de détecteurs thermiques.

Les détecteurs thermiques peuvent comporter une membrane absorbante suspendue au-dessus du substrat de lecture par des piliers d'ancrage. Les piliers de renfort peuvent reposer indirectement sur le substrat de lecture, en étant au contact de piliers inférieurs s'étendant à partir du substrat de lecture, les piliers inférieurs présentant une même hauteur que celle des piliers d'ancrage.

Les piliers inférieurs peuvent être des piliers d'ancrage de détecteurs dits factices non adaptés à détecter le rayonnement électromagnétique, les piliers d'ancrage de chaque détecteur factice assurant le maintien d'une membrane suspendue.

Les détecteurs factices peuvent présenter une structure et des dimensions identiques à celles des détecteurs thermiques de la matrice.

La couche mince d'encapsulation peut comporter des piliers d'appui, agencés en regard de la matrice de détecteurs thermiques, distincts les uns des autres et s'étendant à partir de la portion supérieure jusqu'à reposer sur des piliers d'ancrage des détecteurs thermiques, les piliers d'ancrage de chaque détecteur thermique assurant le maintien d'une membrane suspendue.

Des portions isolantes, réalisées en un matériau électriquement isolant, peuvent être disposées entre et au contact des piliers d'appui et des piliers d'ancrage des détecteurs thermiques.

Les piliers de renfort peuvent reposer directement sur le substrat de lecture, en étant au contact du substrat de lecture.

La couche mince d'encapsulation peut comporter des piliers d'appui, distincts les uns des autres et s'étendant à partir de la portion supérieure jusqu'à reposer sur et au contact du substrat de lecture, disposés chacun entre deux détecteurs thermiques adjacents.

Les piliers de renfort et les piliers d'appui peuvent présenter une structure et des dimensions identiques.

La couche mince d'encapsulation peut comporter une portion périphérique, s'étendant continûment autour de la matrice de détecteurs thermiques, et disposée au-delà des piliers de renfort, dans un plan parallèle au substrat de lecture et suivant une direction opposée à la matrice de détecteurs thermiques, et s'étendant à partir de la portion supérieure en direction du substrat de lecture sur une partie de la hauteur de la cavité.

La gravure chimique humide peut être effectuée à l'acide fluorhydrique en phase vapeur, et les couches sacrificielles minérales peuvent être réalisées en un matériau à base de silicium.

L'invention porte également sur un dispositif de détection d'un rayonnement électromagnétique, comportant :
- un substrat de lecture ;
- une matrice de détecteurs thermiques, reposant sur le substrat de lecture ;
- une structure d'encapsulation, délimitant une cavité dans laquelle est située la matrice de détecteurs thermiques, et comportant :
   ∘ une paroi périphérique, réalisée en un matériau minéral, et délimitant latéralement la cavité ;
   ∘ une couche mince d'encapsulation, comportant une portion supérieure s'étendant au-dessus de la matrice de détecteurs thermiques et reposant sur la paroi périphérique ;
   ∘ la paroi périphérique présente un retrait latéral se traduisant par un élargissement vertical de la cavité, dans un plan parallèle au substrat de lecture, entre le substrat de lecture et la portion supérieure, ce retrait latéral définissant une zone intermédiaire d'une surface du substrat de lecture entourant la matrice de détecteurs thermiques ;
   ∘ la couche mince d'encapsulation comporte des piliers de renfort, agencés dans la zone intermédiaire autour de la matrice de détecteurs thermiques, distincts les uns des autres et s'étendant à partir de la portion supérieure jusqu'à reposer sur le substrat de lecture.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B est des vues en coupe, schématiques et partielles, de deux dispositifs de détection selon des exemples de l'art antérieur, illustrant différentes configurations de la structure d'encapsulation définissant la cavité ;
la figure 2A à 2F sont des vues en coupe, schématiques et partielles, de différentes étapes d'un procédé de fabrication d'un dispositif de détection selon un premier mode de réalisation dans lequel la couche mince d'encapsulation comporte des piliers de renfort reposant sur des piliers d'ancrage de détecteurs factices ;
la figure 3A est une vue de dessus, schématique et partielle, d'un dispositif de détection selon une variante du premier mode de réalisation ;
la figure 3B est une vue en coupe, schématique et partielle, d'un dispositif de détection selon une autre variante du premier mode de réalisation, dans laquelle la couche mince d'encapsulation comporte une portion périphérique ;
la figure 3C est une vue en coupe, schématique et partielle, d'un dispositif de détection selon une autre variante du premier mode de réalisation, dans laquelle les piliers de renfort de la couche mince d'encapsulation reposent sur des piliers inférieurs ;
la figure 4A est une vue en coupe, schématique et partielle, d'un dispositif de détection selon un deuxième mode de réalisation, dans lequel les piliers de renfort de la couche mince d'encapsulation sont des piliers creux qui viennent reposer au contact du substrat de lecture ;
la figure 4B est une vue en coupe, schématique et partielle, d'un dispositif de détection selon une variante du deuxième mode de réalisation, dans lequel les piliers de renfort de la couche mince d'encapsulation sont des piliers pleins ;
la figure 4C est une vue de dessus, schématique et partielle, d'un dispositif de détection selon une autre variante du deuxième mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte d'une manière générale sur un procédé de fabrication d'un dispositif de détection de rayonnement électromagnétique adapté à détecter un rayonnement infrarouge ou térahertz.

Ce dispositif de détection comporte une matrice de détecteurs thermiques situés dans une cavité hermétique. La matrice de détecteurs thermiques forme un réseau de préférence périodique. Chacun des détecteurs thermiques est un détecteur optiquement sensible, et forme un pixel de détection adapté à détecter le rayonnement électromagnétique d'intérêt.

Le procédé de fabrication comporte une étape de réalisation de la matrice de détecteurs thermiques au moyen de couches sacrificielles dites minérales, réalisées en un matériau minéral ou inorganique, ces couches sacrificielles étant destinées à former la paroi périphérique mentionnée précédemment. Il s'agit ici d'un matériau diélectrique à base de silicium permettant également la réalisation d'une couche diélectrique inter-métal du circuit de lecture, c'est-à-dire un matériau électriquement isolant, avec par exemple une constante diélectrique, ou permittivité relative, inférieure ou égale à 3,9, limitant ainsi la capacité parasite entre les interconnexions. Ce matériau minéral ne comporte pas de chaînes carbonées, et peut être un oxyde de silicium SiOₓ ou un nitrure de silicium SiₓN_{y}, voire un matériau organosilicié tel que du SiOC, du SiOCH, ou d'un matériau de type verre fluoré tel que du SiOF. Il s'agit de préférence d'un oxyde de silicium SiOₓ.

Le procédé de fabrication comporte également une étape de suppression partielle des couches sacrificielles minérales par une gravure chimique humide en milieu acide, par exemple à l'acide fluorhydrique en phase vapeur (HF vapeur). Par gravure humide, on entend d'une manière générale que l'agent de gravure se présente en phase liquide ou en phase vapeur, et ici, de préférence, en phase vapeur.

La cavité hermétique est délimitée par une structure d'encapsulation qui comporte :
- plusieurs couches minces transparentes au rayonnement électromagnétique à détecter, dont notamment une couche mince d'encapsulation dont une portion supérieure s'étend au-dessus de la matrice de détecteurs thermiques et délimite verticalement la cavité, et une couche mince de scellement des évents 33 ;
- une paroi périphérique qui s'étend continûment autour de la matrice de détecteurs thermiques et délimite latéralement la cavité. Comme explicité plus loin, la paroi périphérique est formée d'une portion non gravée de couches sacrificielles minérales.

Par couche mince, on entend une couche formée par les techniques de dépôt de matériau de la microélectronique, dont l'épaisseur est de préférence inférieure ou égale à 10µm. Par ailleurs, une couche mince est dite transparente lorsqu'elle présente un coefficient de transmission supérieur ou égal à 50%, de préférence à 75%, voire à 90% pour une longueur d'onde centrale de la gamme spectrale du rayonnement électromagnétique à détecter.

Comme détaillé plus loin, à la suite de l'étape de gravure chimique humide, la paroi périphérique présente un retrait latéral se traduisant par un élargissement vertical de la cavité entre le substrat de lecture et la portion supérieure, dans un plan parallèle au plan du substrat de lecture. La cavité présente alors une forme évasée suivant une direction verticale +Z opposée au substrat de lecture. Autrement dit, la cavité est plus large au niveau de la portion supérieure qu'au niveau du substrat de lecture. La paroi périphérique est donc plus éloignée de la matrice de détecteurs thermiques au niveau de la portion supérieure qu'au niveau du substrat de lecture.

Ce retrait latéral de la paroi périphérique s'étend autour de la matrice de détecteurs thermiques, dans un plan XY parallèle au substrat de lecture, définissant ainsi une zone intermédiaire Zr dite de renfort de la surface du substrat de lecture. Dans cette zone de retrait, la couche mince d'encapsulation comporte des piliers de renfort, distincts les uns des autres et reposant sur le substrat de lecture, et agencés autour de la matrice de détecteurs thermiques. Ces piliers de renfort permettent de renforcer la tenue mécanique de la structure d'encapsulation, et notamment éviter un décollement de la portion supérieure vis-à-vis de la paroi périphérique. Ces piliers de renfort peuvent présenter différentes configurations :
- selon un premier mode de réalisation, ils reposent indirectement sur le substrat de lecture, par exemple en venant reposer sur les piliers d'ancrage de détecteurs factices ou sur des piliers inférieurs ;
- selon un deuxième mode de réalisation, ils reposent directement sur le substrat de lecture, en venant alors au contact du substrat de lecture.

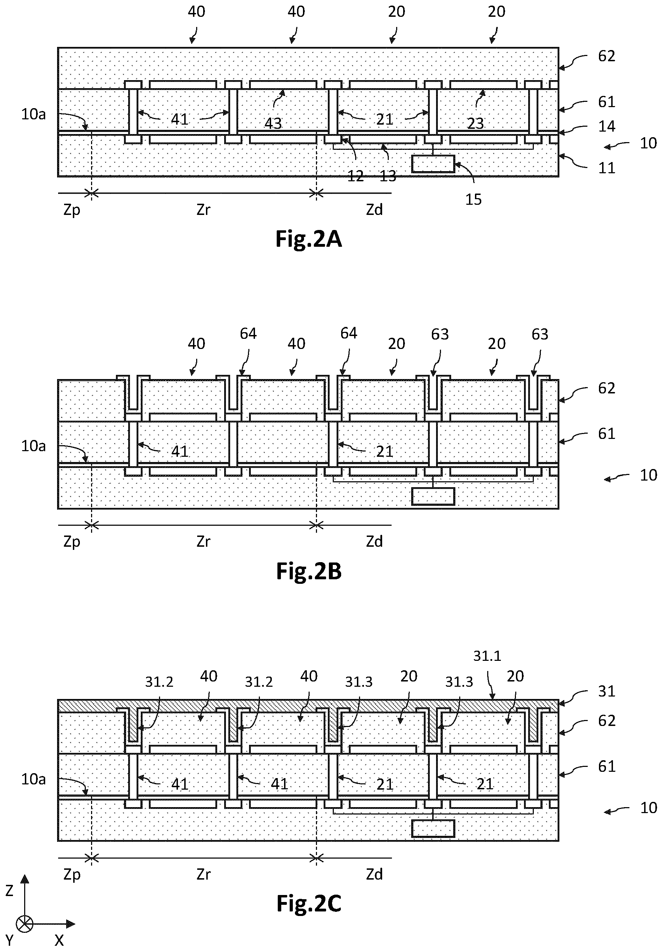

Les figures 2A à 2G illustrent différentes étapes d'un procédé de fabrication d'un dispositif de détection 1 selon un premier mode de réalisation dans lequel les piliers de renfort 31.2 de la couche mince d'encapsulation 31 reposent indirectement sur le substrat de lecture 10, ici via des piliers d'ancrage 41 de détecteurs factices 40 réalisés dans la zone de renfort Zr. Par souci de clarté, seule une partie du dispositif de détection 1 est représentée sur les figures.

Le dispositif de détection 1 comporte une matrice de détecteurs thermiques 20 dits sensibles, située dans une cavité hermétique 2 définie par une structure d'encapsulation 30. Comme détaillé par la suite, la structure d'encapsulation 30 comporte une couche mince d'encapsulation 31 dont une portion supérieure 31.1 s'étend au-dessus de la matrice de détecteurs thermiques 20 et repose sur une paroi périphérique 32 formée d'une portion non gravée des couches sacrificielles minérales 61, 62. La couche mince d'encapsulation 31 comporte des piliers de renfort 31.2, situés dans une zone intermédiaire Zr dite de renfort, autour de la matrice de détecteurs thermiques 20, qui reposent sur le substrat de lecture 10, ici via des piliers d'ancrage 41 de détecteurs factices 40.

A titre d'exemple, les détecteurs thermiques sensibles 20 (c'est-à-dire les détecteurs de la matrice), sont ici adaptés à détecter un rayonnement infrarouge dans la gamme LWIR (*Long Wavelength Infrared*, en anglais) dont la longueur d'onde est comprise entre 8µm et 14µm environ. Ils sont ici structurellement identiques les uns aux autres, et sont connectés à un circuit de lecture 15 situé dans le substrat (dit alors substrat de lecture 10). Les détecteurs thermiques sensibles 20 forment ainsi des pixels sensibles agencés préférentiellement de manière périodique, et peuvent présenter une dimension latérale dans le plan du substrat de lecture 10, de l'ordre de quelques dizaines de microns, par exemple égale à 10µm environ voire moins.

On définit ici et pour la suite de la description un repère direct tridimensionnel XYZ, où le plan XY est sensiblement parallèle au plan du substrat de lecture 10, l'axe Z étant orienté suivant une direction sensiblement orthogonale au plan du substrat de lecture 10 en direction des détecteurs thermiques 20. Les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'entendent comme étant relatifs à un positionnement croissant lorsqu'on s'éloigne du substrat de lecture 10 suivant la direction +Z.

En référence à la fig.2A, on réalise la matrice de détecteurs thermiques 20 sur le substrat de lecture 10 au moyen d'une première couche sacrificielle minérale 61, ces détecteurs thermiques 20 étant recouverts par une deuxième couche sacrificielle minérale 62. Dans cet exemple, plusieurs détecteurs dits factices 40 sont également réalisés. Comme explicité plus loin, les détecteurs thermiques 20 de la matrice sont des détecteurs sensibles (optiquement actifs) destinés à fournir un signal électrique en réponse à la détection du rayonnement électromagnétique d'intérêt. En revanche, les détecteurs factices 40 ne sont pas des détecteurs sensibles, dans le sens où ils ne fournissent pas au circuit de lecture un signal électrique représentatif du rayonnement électromagnétique à détecter.

Le substrat de lecture 10 est réalisé à base de silicium, et est formé d'un substrat support 11 contenant le circuit de lecture 15 adapté à commander et lire les détecteurs thermiques sensibles 20. Il peut ne pas être adapté à commander et lire les détecteurs factices 40. Le circuit de lecture 15 se présente ici sous la forme d'un circuit intégré CMOS. Il comporte entre autres des portions de lignes conductrices séparées les unes des autres par des couches isolantes inter-métal réalisées en un matériau diélectrique, par exemple un matériau minéral à base de silicium tel qu'un oxyde de silicium SiOₓ, un nitrure de silicium SiNₓ, entre autres. Des portions conductrices affleurent la surface du substrat support 11, et assurent la connexion électrique des piliers d'ancrage 21 des détecteurs thermiques sensibles 20 au circuit de lecture. De plus, une ou plusieurs portions de connexion 12 (non représentées) affleurent la surface du substrat support 11, et permettent de connecter le circuit de lecture 15 à un dispositif électronique externe. En variante, le circuit de lecture 15 peut être adapté à lire un signal électrique émis par les détecteurs factices 40, notamment lorsque ceux-ci sont adaptés à fournir un signal électrique représentatif de la température du substrat de lecture 10.

Le substrat de lecture 10 peut comporter un réflecteur 13 disposé en regard de chaque détecteur sensible 20. Le réflecteur 13 peut être formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 23 du détecteur sensible 20, et est destiné à former avec celle-ci une cavité interférentielle quart d'onde vis-à-vis du rayonnement électromagnétique à détecter.

Enfin, le substrat de lecture 10 comporte ici une couche de protection 14 de manière à recouvrir notamment la couche isolante inter-métal supérieure. Cette couche de protection 14 correspond ici à une couche d'arrêt de gravure réalisée en un matériau sensiblement inerte à l'agent de gravure chimique utilisé ultérieurement pour supprimer les différentes couches sacrificielles minérales 61, 62, par exemple au milieu HF en phase vapeur. Cette couche de protection 14 forme ainsi une couche hermétique et chimiquement inerte, et électriquement isolante pour éviter tout court-circuit entre les piliers d'ancrage 21. Elle permet ainsi d'éviter que les couches isolantes inter-métal sous-jacentes ne soient gravées lors de cette étape de suppression des couches sacrificielles minérales. Elle peut être formée en un oxyde ou nitrure d'aluminium, voire en trifluorure d'aluminium, ou encore en silicium amorphe non intentionnellement dopé.

On réalise ensuite les détecteurs thermiques sensibles 20 sur le substrat de lecture 10, ainsi que, dans cet exemple, les détecteurs factices 40. Ces étapes de réalisation sont identiques ou similaires à celles décrites notamment dans le document EP3239670A1. Les détecteurs thermiques sensibles 20 et les détecteurs factices 40 présentent ici avantageusement la même structure. Ils sont ici des microbolomètres comportant chacun une membrane absorbante 23, 43, i.e. apte à absorber le rayonnement électromagnétique à détecter, suspendue au-dessus du substrat de lecture 10 par des piliers d'ancrage 21, 41, et isolée thermiquement de celui-ci par des bras de maintien et d'isolation thermique (non représentés). L'obtention de membranes absorbantes 23, 43 est classiquement obtenue par des techniques de micro-usinage de surface consistant à réaliser les piliers d'ancrage 21, 41 au travers d'une première couche sacrificielle minérale 61, et les bras d'isolation thermique ainsi que les membranes absorbantes 23, 43 sur la face supérieure de la couche sacrificielle minérale 61. Chaque membrane absorbante 23, 43 comporte en outre un transducteur thermométrique, par exemple un matériau thermistance, relié au circuit de lecture par des connexions électriques prévues dans les bras d'isolation thermique et dans les piliers d'ancrage. La membrane absorbante 43 peut, en variante, ne pas comporter de transducteur thermométrique. Par ailleurs, les bras de maintien de la membrane absorbante 43 peuvent ne pas comporter de connecteurs électriques reliant le transducteur thermométrique au circuit de lecture 15.

Les détecteurs thermiques 20 de la matrice sont des détecteurs sensibles (optiquement actifs), c'est-à-dire qu'ils sont adaptés à détecter le rayonnement électromagnétique d'intérêt et sont connectés électriquement au circuit de lecture présent dans le substrat de lecture 10. Ils forment chacun un pixel de détection. En revanche, les détecteurs factices 40 ne sont pas destinés à fournir un signal électrique représentatif du rayonnement électromagnétique reçu. Ils peuvent alors ne pas être électriquement connectés au circuit de lecture 15 (mais ils pourraient l'être). Comme détaillé plus loin, les détecteurs factices 40, et en particulier leurs piliers d'ancrage 41, sont destinés à participer au renforcement mécanique de la structure d'encapsulation 30.

Les détecteurs thermiques sensibles 20 sont situés dans une zone centrale dite de détection Zd de la surface 10a du substrat de lecture 10, et les détecteurs factices 40 sont situés dans une zone intermédiaire dite de renfort Zr de cette surface 10a, qui entoure continûment la zone de détection Zd dans le plan XY. Plus précisément, on définit plusieurs zones au sein de la surface 10a du substrat de lecture 10 :
- une zone centrale Zd dite de détection, dans laquelle est située la matrice de détecteurs thermiques 20 (sensibles), c'est-à-dire les pixels de détection. La surface 10a du substrat de lecture 10 dans la zone de détection Zd est destinée à être libérée entièrement des couches sacrificielles minérales 61, 62 ;
- une zone intermédiaire Zr de renfort, qui entoure continûment la zone de détection Zd dans le plan XY, et dans laquelle sont destinés à être situés les piliers de renfort 31.2 de la couche mince d'encapsulation 31, et, dans ce mode de réalisation, également les détecteurs factices 40. Elle sera au moins en partie recouverte par les couches sacrificielles minérales 61, 62 partiellement gravées ;
- une zone périphérique Zp, qui entoure continûment la zone de renfort Zr dans le plan XY, et dans laquelle la portion supérieure 31.1 de la couche mince d'encapsulation 31 est destinée à venir reposer au contact de la paroi périphérique 32 (celle-ci étant formée par les portions non gravées des couches sacrificielles minérales 61, 62).

On dépose ensuite une deuxième couche sacrificielle minérale 62 préférentiellement de même nature que la couche sacrificielle minérale 61. La couche sacrificielle minérale 62 recouvre ainsi la couche sacrificielle minérale 61 ainsi que les détecteurs sensibles 20 et les détecteurs factices 40. Elle présente une face supérieure sensiblement plane, opposée au substrat de lecture 10 suivant l'axe Z. D'une manière générale, les différentes couches sacrificielles minérales 61, 62 peuvent être un oxyde de silicium obtenu à partir d'un composé TEOS (orthosilicate de tétraéthyle) déposé par PECVD.

En référence à la fig.2B, on réalise plusieurs échancrures 63 (vias) destinées à permettre la réalisation de piliers de renfort 31.2 d'une couche mince d'encapsulation 31 de la structure d'encapsulation 30. Ces échancrures 63 s'étendent à partir de la face supérieure de la couche sacrificielle minérale 62 suivant l'axe Z pour déboucher sur au moins une partie des piliers d'ancrage 41 des détecteurs factices 40. Dans cet exemple, on réalise également des échancrures destinées à permettre la réalisation de piliers d'appui 31.3 de la couche mince d'encapsulation 31, ces échancrures débouchant sur les piliers d'ancrage 21 des détecteurs sensibles 20. Notons ici que, dans ce mode de réalisation, la couche mince d'encapsulation 31 comportera des piliers de renfort 31.2 venant reposer sur les piliers d'ancrage 41 des détecteurs factices 40, ainsi que des piliers d'appui 31.3 venant reposer sur les piliers d'ancrage 21 des détecteurs sensibles 20. Les piliers d'appui 31.3 et les piliers de renfort 31.2 présentent avantageusement une même structure et des mêmes dimensions, et diffèrent les uns des autres en ce que les premiers sont agencés dans la zone de détection Zd alors que les seconds sont agencés dans la zone de renfort Zr.

On réalise ensuite, avantageusement, une pluralité de portions isolantes 64 dans les échancrures débouchant sur les piliers d'ancrage 21 des détecteurs sensibles 20, et, pour obtenir une même adhérence sur tous les piliers, de préférence également dans les échancrures débouchant sur les piliers d'ancrage 41 des détecteurs factices 40. Ces portions isolantes 64 sont des portions d'une couche mince réalisée en un matériau électriquement isolant. Elles permettent d'éviter un court-circuit électrique entre les détecteurs sensibles 20 et la couche mince d'encapsulation 31 via ses piliers d'appui 31.3, et le cas échéant via les piliers de renfort 31.2. Pour cela, on dépose une couche mince isolante sur la surface rendue libre des piliers d'ancrage 21, 41 à l'intérieur des échancrures. La couche mince isolante est ici avantageusement gravée localement en regard des détecteurs sensibles 20, de manière à ne pas réduire la transmission du rayonnement électromagnétique à détecter, mais elle pourrait ne pas être gravée. Elle peut présenter une épaisseur comprise entre 10nm et 100nm environ. Elle est réalisée en un matériau inerte à la gravure chimique humide mise en oeuvre lors de la suppression des couches sacrificielles minérales, qui peut être choisi parmi l'AlN, l'Al₂O₃, l'HfO₂.

En référence à la fig.2C, on réalise la couche mince d'encapsulation 31 de la structure d'encapsulation 30, cette couche mince d'encapsulation 31 présentant des piliers de renfort 31.2, distincts les uns des autres et situés dans la zone de renfort Zr, reposant sur le substrat de lecture 10 via les piliers d'ancrage 41 des détecteurs factices 40. Dans cet exemple, la couche mince d'encapsulation 31 comporte également des piliers d'appui 31.3 reposant sur le substrat de lecture 10 via les piliers d'ancrage 21 des détecteurs sensibles 20.

Pour cela, on procède au dépôt conforme de la couche mince d'encapsulation 31, réalisée en un matériau transparent au rayonnement électromagnétique d'intérêt et inerte à la gravure chimique humide mise en oeuvre ultérieurement, d'une épaisseur comprise par exemple entre 200nm et 2µm, par exemple égale à 800nm environ voire moins, par exemple du silicium amorphe, du germanium amorphe, un alliage silicium-germanium amorphe, entre autres. La couche mince d'encapsulation 31 est déposée sur la couche sacrificielle minérale 62 ainsi que dans les échancrures 63, par exemple par une technique de dépôt chimique en phase vapeur (CVD pour *Chemical Vapor Deposition,* en anglais).

La couche mince d'encapsulation 31 comprend ainsi, réalisés d'un seul tenant :
- une portion supérieure 31.1, sensiblement plane dans le plan XY, qui s'étend au-dessus et à distance suivant l'axe Z des détecteurs sensibles 20 et des détecteurs factices 40, et recouvre la couche sacrificielle minérale 62 ;
- une pluralité de piliers de renfort 31.2, formés d'un seul tenant avec la portion supérieure 31.1, qui s'étendent suivant l'axe Z à partir de la portion supérieure 31.1 dans les échancrures 63 jusqu'aux piliers d'ancrage 41 des détecteurs factices 40. Les piliers de renfort 31.2 sont situés dans la zone de renfort Zr.
- avantageusement, une pluralité de piliers d'appui 31.3, formés d'un seul tenant avec la portion supérieure 31.1, qui s'étendent suivant l'axe Z à partir de la portion supérieure 31.1 dans les échancrures jusqu'aux piliers d'ancrage des détecteurs sensibles 20. Les piliers d'appui 31.3 sont situés dans la zone de détection Zd.

Les piliers d'appui 31.3 et de renfort 31.2 présentent des dimensions dans le plan XY de l'ordre de celles des piliers d'ancrage 21, 41. Ainsi, les piliers d'ancrage 21, 41 peuvent comporter chacun une portion verticale de dimensions dans le plan XY de l'ordre de 0.5µm à 1µm surmontée par une portion supérieure 31.1 débordant latéralement de l'ordre de 0.2µm à 0.5µm vis-à-vis de la portion verticale. Les piliers d'appui 31.3 et de renfort 31.2 peuvent présenter ici des dimensions dans le plan XY de l'ordre de 0.5µm à 2µm environ.

A la différence du document EP3239670A1, la couche mince d'encapsulation 31 ne comporte pas une paroi périphérique qui délimite latéralement la cavité 2, c'est-à-dire une paroi périphérique de la couche mince d'encapsulation 31 qui s'étendrait jusqu'au substrat de lecture 10 et entoure continûment la matrice de détecteurs thermiques 20 dans le plan XY. Dans le cadre de l'invention, la paroi périphérique 32 est réalisée en une portion non gravée des couches sacrificielles minérales 61, 62 et non pas en le matériau de la couche mince d'encapsulation 31.

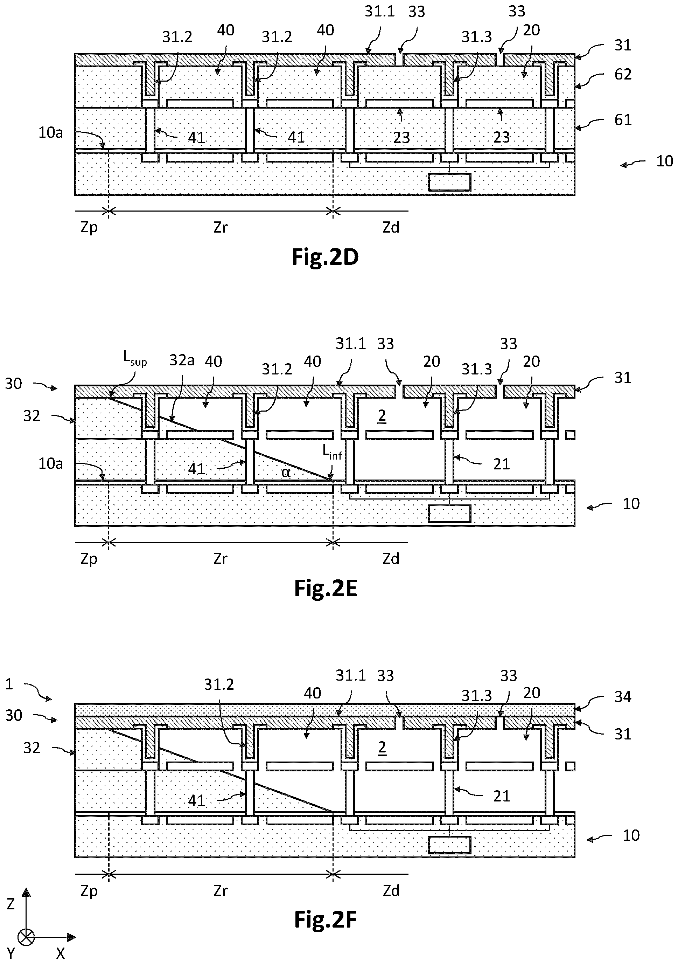

En référence à la fig.2D, on réalise les évents 33 au travers de la couche mince d'encapsulation 31. Ces évents 33 débouchent sur la couche sacrificielle minérale 62 et sont destinés à permettre l'évacuation des différentes couches sacrificielles minérales 61, 62 hors de la cavité 2. Ils sont disposés uniquement en regard de la zone de détection Zd, et ne sont donc pas situés en regard de la zone de renfort Zr ni de la zone périphérique Zp. Ainsi, ils permettront de libérer totalement la surface 10a du substrat de lecture 10 dans la zone de détection Zd, et de former la paroi périphérique 32. Dans cet exemple, les évents 33 sont situés à la perpendiculaire des membranes absorbantes 23 de tout ou partie des détecteurs thermiques sensibles 20, mais ils peuvent être disposés différemment, notamment à la perpendiculaire de leurs piliers d'ancrage 21. Les évents 33 peuvent présenter différentes formes dans le plan XY, par exemple une forme circulaire d'un diamètre de 0.4µm voire moins.

En référence à la fig.2E, on effectue une gravure chimique adaptée à supprimer partiellement, à partir des évents 33, les couches sacrificielles minérales 61, 62. La gravure chimique est une gravure humide en milieu acide, par exemple à l'acide fluorhydrique en phase vapeur. Les produits de la réaction chimique sont évacués au travers des évents 33.

Du fait de la disposition des évents 33 uniquement en regard de la zone de détection Zd, l'agent de gravure supprime entièrement les couches sacrificielles minérales 61, 62 situées dans la zone de détection Zd, mais la gravure chimique est effectuée de sorte que l'agent de gravure ne grave pas une portion périphérique des couches sacrificielles minérales 61, 62 qui s'étend autour de la zone de détection Zd. La portion non gravée des couches sacrificielles minérales 61, 62, sur laquelle repose la portion supérieure 31.1 de la couche mince d'encapsulation 31, définit la zone périphérique Zp.

Cependant, les inventeurs ont constaté qu'une gravure chimique en milieu acide des couches sacrificielles minérales 61, 62 conduit à ce que la paroi périphérique 32 présente un retrait latéral, de sorte que la cavité 2 présente un élargissement vertical dans le plan XY, c'est-à-dire qu'elle présente une forme évasée suivant la direction +Z. Les dimensions de la cavité 2 dans le plan XY sont plus grandes au niveau de la portion supérieure 31.1 qu'au niveau de la surface libérée du substrat de lecture 10. Ce profil de gravure des couches sacrificielles minérales 61, 62 est ainsi différent de celui illustré schématiquement dans la fig.1 du document WO2014/100648A1. Il est obtenu lorsque les couches sacrificielles sont réalisées en un matériau minéral et que la gravure est une gravure chimique en milieu acide en milieu confiné.

Ainsi, la paroi périphérique 32 présente une face latérale 32a (qui délimite la cavité 2 dans le plan XY) qui s'étend verticalement de manière inclinée suivant l'axe Z. Autrement dit, la face latérale 32a présente une extrémité supérieure Lₛᵤₚ située au contact de la portion supérieure 31.1 de la couche mince d'encapsulation 31 qui est plus éloignée de la zone de détection que l'extrémité inférieure L_{inf} située au contact du substrat de lecture 10 suivant une direction opposée aux détecteurs thermiques 20. L'extrémité supérieure Lₛᵤₚ n'est ainsi pas à la verticale de l'extrémité inférieure L_{inf}. Dans un plan vertical passant par l'axe Z, la distance entre deux points opposés de l'extrémité supérieure Lₛᵤₚ est supérieure à la distance entre deux points opposés de l'extrémité inférieure L_{inf}. Sur les figures, ce retrait latéral supérieur de la paroi périphérique 32 peut être monotone suivant la direction +Z, ou peut ne pas être entièrement monotone. Ainsi, il est possible que la face latérale 32a présente un léger retour en direction de la zone de détection Zd, en particulier au niveau de la portion supérieure 31.1.

Ce retrait latéral supérieur de la paroi périphérique 32 est peut-être dû au fait que l'attaque chimique en milieu acide de couches sacrificielles minérales 61, 62, dans un milieu confiné (ici du fait de la présence de la couche mince d'encapsulation 31), présente une vitesse de gravure latérale (dans le plan XY) supérieure à la vitesse de gravure verticale (suivant l'axe Z). Aussi, il apparaît que, dans une cavité 2 de 4µm environ de hauteur, le temps nécessaire pour supprimer les couches sacrificielles minérales 61, 62 dans la zone de détection Zd conduit à un retrait latéral supérieur de plusieurs dizaines de microns, par exemple de l'ordre de 40µm, 60µm, voire 70µm.

Selon l'invention, la présence de ce retrait latéral supérieur de la paroi périphérique 32 est mise à profit pour améliorer la tenue mécanique de la structure d'encapsulation 30, ici en disposant localement, autour de la matrice de détecteurs thermiques 20, dans la zone intermédiaire de renfort Zr, des piliers de renfort 31.2 réalisés d'un seul tenant avec la portion supérieure 31.1 de la couche mince d'encapsulation 31. Les piliers de renfort 31.2 sont donc disposés à la périphérie de la cavité 2. Ainsi, il y a une transmission de contraintes mécaniques entre la couche mince d'encapsulation 31 et le substrat de lecture 10, qui contribue à améliorer la tenue mécanique de la structure d'encapsulation 30. On réduit notamment les risques de décollement de la structure d'encapsulation 30 vis-à-vis du substrat de lecture 10, et plus précisément le décollement de la portion supérieure 31.1 vis-à-vis de la paroi périphérique 32. On améliore également la tenue mécanique de la structure d'encapsulation 30 lorsque celle-ci subit une force de pression suivant la direction -Z du fait que la pression dans la cavité 2 peut être inférieure à la pression de l'environnement extérieur.

La valeur du retrait latéral supérieur (largeur de la zone de renfort Zr) peut être définie comme la distance entre l'extrémité inférieure L_{inf} et l'extrémité supérieure Lₛᵤₚ, suivant une direction opposée à la matrice de détecteurs thermiques 20, de préférence dans un plan passant par l'axe Z et orthogonal à la face latérale 32a. Ce retrait latéral supérieur peut être au moins égal à plusieurs microns voire à plusieurs dizaines de microns. Elle peut ainsi être supérieure ou égale à 10µm, et par exemple supérieure ou égale à 25µm, et par exemple être de l'ordre de 40µm. Dans le cas où les détecteurs sensibles 20 de la matrice sont agencés de manière périodique à un pas de 10µm environ, il est alors possible de réaliser plusieurs lignes parallèles de détecteurs factices 40 dans la zone de renfort Zr, s'étendant autour de la zone de détection Zd. Les détecteurs factices 40 peuvent alors présenter une structure identique ou similaire à celle des détecteurs sensibles 20, la couche mince d'encapsulation 31 comportant alors des piliers de renfort 31.2 venant reposer sur les piliers d'ancrage 41 des détecteurs factices 40.

Par ailleurs, la face latérale 32a peut former un angle d'inclinaison α inférieur ou égal à 25°, voire inférieur ou égal à 15°, voire inférieur ou égal à 10°, cet angle d'inclinaison α étant mesuré au niveau de l'extrémité inférieure L_{inf} par rapport au plan XY, en direction de l'extrémité supérieure Lₛᵤₚ. Dans le cas où le retrait latéral supérieur est de 40µm environ et que la hauteur de la cavité 2 (distance suivant l'axe Z entre la portion supérieure 31.1 de la couche mince d'encapsulation 31 et le substrat de lecture 10) est 4µm environ, cet angle d'inclinaison α est égal à 6° environ.

Par ailleurs, du fait que la couche mince d'encapsulation 31 comporte des piliers de renfort 31.2 dans la zone de renfort Zr, et avantageusement des piliers d'appui 31.3 dans la zone de détection Zd, la tenue mécanique de la structure d'encapsulation 30 est davantage renforcée. Il est alors possible de diminuer l'épaisseur de la couche mince d'encapsulation 31. Celle-ci présente habituellement, au niveau de la portion supérieure 31.1, une épaisseur par exemple comprise entre 200nm et 2µm, par exemple égale à 800nm environ. Il est alors possible d'envisager de réduire encore son épaisseur à moins de 800nm, voire à moins de 500nm, par exemple à 200nm environ.

En référence à la fig.2F, on dépose une couche de scellement 34 sur la couche mince d'encapsulation 31 avec une épaisseur suffisante pour assurer le scellement, i.e. le bouchage, des évents 33. Elle s'étend au moins en regard de la zone de détection Zd puisque les évents 33 y sont situés. De préférence, elle recouvre entièrement la couche mince d'encapsulation 31 et s'étend donc en regard des zones de renfort Zr et périphérique Zp. La couche de scellement 34 est transparente au rayonnement électromagnétique à détecter, et peut être réalisée en germanium avec une épaisseur de 1.7µm environ. On peut également déposer une couche antireflet (non représentée) permettant d'optimiser la transmission du rayonnement électromagnétique au travers de la structure d'encapsulation 30. Cette couche antireflet peut être réalisée en sulfure de zinc avec une épaisseur de 1.2µm environ.

On obtient ainsi une cavité hermétique 2, de préférence sous vide ou à pression réduite, dans laquelle sont logés les détecteurs thermiques sensibles 20 (dans la zone de détection Zd). La structure d'encapsulation 30 comporte donc la couche mince d'encapsulation 31 et la paroi périphérique 32, cette dernière étant formée par la portion non gravée des couches minces sacrificielles 61, 62. Du fait que la paroi périphérique 32 (et donc la cavité 2) présente une forme évasée, la couche mince d'encapsulation 31 peut alors comporter des piliers de renfort 31.2 dans la zone de renfort Zr, ceux-ci reposant sur le substrat de lecture 10 (ici via les piliers d'ancrage 41 des détecteurs factices 40). La structure d'encapsulation 30 présente donc une tenue mécanique renforcée.

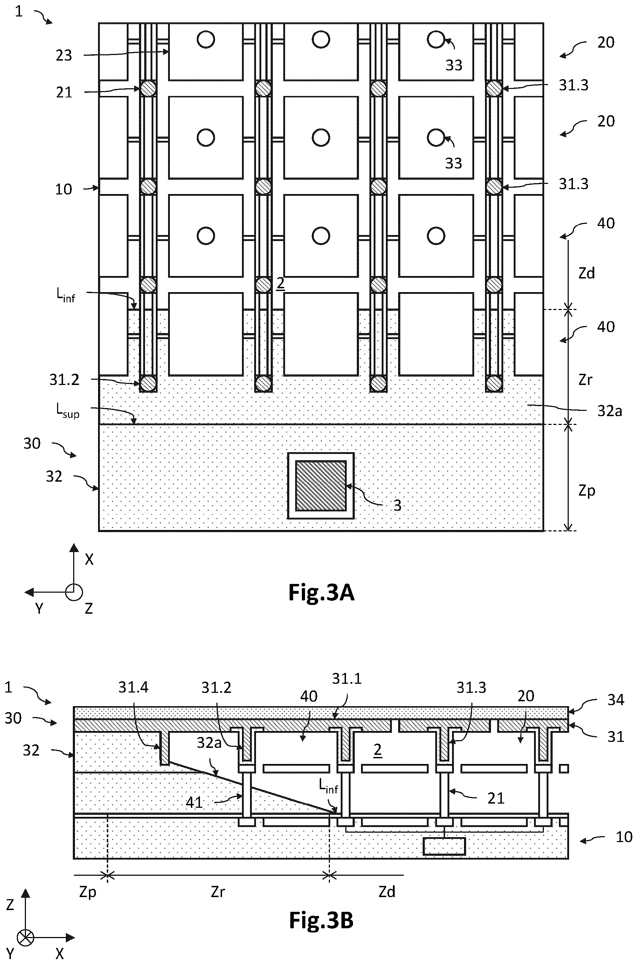

La figure 3A est une vue de dessus, schématique et partielle, d'un dispositif de détection 1 selon une variante du premier mode de réalisation, lequel est similaire à celui décrit en référence aux fig.2A à 2F et n'en diffère essentiellement que par le nombre de détecteurs factices 40 disposés radialement dans la zone de renfort Zr. Comme précédemment, par souci de clarté, seule la bordure du dispositif de détection 1 n'est représentée. La portion supérieure 31.1 de la couche mince d'encapsulation 31 et la couche mince de scellement ne sont pas représentées.

Les évents 33 sont ici disposés uniquement dans la zone de détection Zd, ici au-dessus de chaque membrane absorbante 23 des détecteurs sensibles 20, et permettent de supprimer totalement les couches sacrificielles minérales 61, 62 dans la zone de détection Zd. Ils peuvent néanmoins être situés ailleurs qu'au-dessus des membranes absorbantes 23, comme par exemple au-dessus d'au moins une partie des piliers d'ancrage 21. Dans cet exemple, la couche mince d'encapsulation 31 (non représentée) comporte des piliers d'appui 31.3 qui viennent reposer sur les piliers d'ancrage 21 des détecteurs sensibles 20.

Dans la zone de renfort Zr, aucun évent n'est présent. Aussi, l'attaque chimique a supprimé les couches sacrificielles minérales 61, 62 à partir des évents 33 et de la zone de détection Zd, de sorte que la portion non gravée des couches sacrificielles minérales 61, 62, c'est-à-dire la paroi périphérique 32, présente une face latérale 32a inclinée dans la zone de renfort Zr. Ce retrait latéral supérieur est mis à profit en disposant des portions de renfort dans la zone de renfort Zr reposant sur le substrat de lecture 10. Dans cet exemple, les détecteurs factices 40 présentent une structure et des dimensions identiques à celles des détecteurs sensibles 20. Une seule ligne de détecteurs factices 40 borde ici la périphérie de la zone de détection Zd, mais plusieurs lignes sont possibles, en fonction de la valeur du retrait latéral supérieur.

Dans cet exemple, la paroi périphérique 32 s'étend, hors de la cavité 2, de manière à recouvrir entièrement le substrat de lecture 10. Un plot de connexion électrique 3 (non représenté à l'échelle par souci de clarté) permet de raccorder le circuit de lecture avec un dispositif électronique externe (non représentée). Ce plot de connexion électrique 3 était initialement recouvert par les couches sacrificielles minérales 61, 62, et éventuellement par la couche mince d'encapsulation 31 et la couche mince de scellement 34. Celles-ci sont alors localement supprimées par gravure sèche de manière à ouvrir le plot de connexion électrique 3 et à en permettre l'accès.

La figure 3B est une vue en coupe, schématique et partielle, d'un dispositif de détection 1 selon une autre variante du premier mode de réalisation, qui diffère de celui décrit en référence aux fig.2A à 2F essentiellement en ce que la couche mince d'encapsulation 31 comporte une portion périphérique 31.4 qui permet de limiter le retrait latéral supérieur de la paroi périphérique 32.

Cette portion périphérique 31.4 est réalisée d'un seul tenant avec la portion supérieure 31.1, lors du dépôt de la couche mince d'encapsulation 31. Elle s'étend en direction du substrat de lecture 10, mais son extrémité inférieure est libre : elle ne repose pas sur le substrat de lecture 10 ni directement, ni indirectement. Elle peut présenter une hauteur (suivant l'axe Z) sensiblement égale aux piliers de renfort 31.2. Cette portion périphérique 31.4 s'étend de manière continue autour de la zone de détection Zd, et est située au-delà des piliers de renfort 31.2 dans le plan XY. La présence de cette portion périphérique 31.4 permet alors de réduire le retrait latéral supérieur dans la mesure où elle bloque la propagation de l'agent de gravure au niveau de la portion supérieure 31.1 de la couche mince d'encapsulation 31. Aussi, la face latérale 32a s'étend à partir de l'extrémité inférieure L_{inf} de la surface latérale 32a sur le substrat de lecture 10 jusqu'à la portion périphérique 31.4.

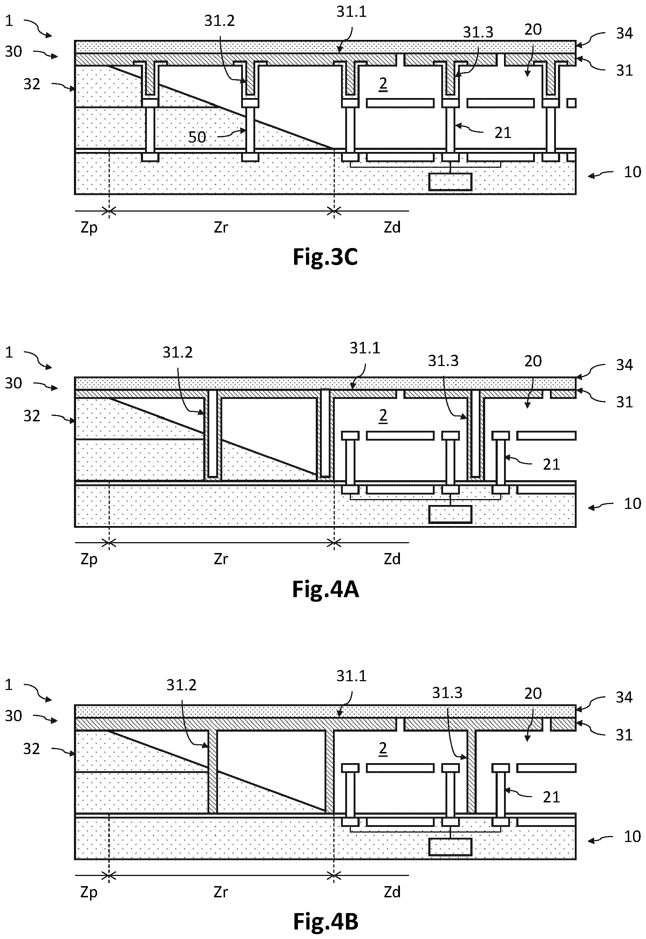

La figure 3C est une vue en coupe, schématique et partielle, d'un dispositif de détection 1 selon une autre variante du premier mode de réalisation, qui diffère de celui décrit en référence aux fig.2A à 2F essentiellement en ce que les piliers de renfort 31.2 ne reposent pas sur les piliers d'ancrage 41 des détecteurs factices 40, mais sur des piliers inférieurs 50, lesquels peuvent être identiques ou similaires aux piliers d'ancrage 21. Il apparaît que, de manière surprenante, le retrait latéral est moins important dans cette configuration que dans le cas des fig.2A à 2F. A titre d'exemple, il peut être de l'ordre de 40µm au lieu de 60 à 70µm.

Les figures 4A et 4B sont des vues en coupe, schématiques et partielles, d'un dispositif de détection 1 selon un deuxième mode de réalisation de réalisation, dans lequel les piliers de renfort 31.2 de la couche mince d'encapsulation 31 viennent au contact du substrat de lecture 10, c'est-à-dire qu'ils reposent directement sur le substrat de lecture 10, et ne reposent pas sur des piliers d'ancrage 41 de détecteurs factices 40 ou sur des piliers inférieurs 50. Aussi, le dispositif de détection 1 ne comporte pas de détecteurs factices 40 ni de piliers inférieurs 50 situés dans la zone de renfort Zr. Dans ces exemples, les piliers de renfort 31.2 sont avantageusement identiques aux piliers d'appui 31.3, lesquels sont identiques ou similaires à ceux décrits dans le document EP3067674A2.

En référence à la fig.4A, les piliers de renfort 31.2 et les piliers d'appui 31.3 sont creux dans le sens où chaque pilier 31.2, 31.3 est formé d'une paroi latérale qui délimite dans le plan XY un espace interne qui n'est pas rempli par le matériau de la couche mince d'encapsulation 31. Cet espace interne est au moins en partie vide. Ces piliers 31.2, 31.3 sont réalisés par dépôt conforme de la couche mince d'encapsulation 31 dans des échancrures pratiquées dans les couches sacrificielles minérales 61, 62 qui débouchent sur le substrat de lecture 10. Les dimensions des échancrures dans le plan XY et l'épaisseur de la couche mince d'encapsulation 31 sont définies de manière à ce que la portion de couche déposée dans les échancrures ne les remplisse pas et forme ainsi une paroi latérale qui délimite cet espace creux.

En référence à la fig.4B, les piliers de renfort 31.2 et les piliers d'appui 31.3 sont pleins, et non pas creux, c'est-à-dire que chaque pilier 31.2, 31.3 est formé d'une même paroi verticale dont la surface dans le plan XY délimite un espace plein et rempli par le matériau de la couche mince d'encapsulation 31.

Dans ces variantes de réalisation, une seule ligne de piliers de renfort 31.2 s'étend dans la zone de renfort Zr autour de la zone de détection Zd. Cependant, plusieurs lignes parallèles de piliers de renfort 31.2 sont possibles, en fonction de l'importance du retrait latéral de la paroi périphérique 32 d'une part, et du pas d'agencement radial des piliers de renfort 31.2.

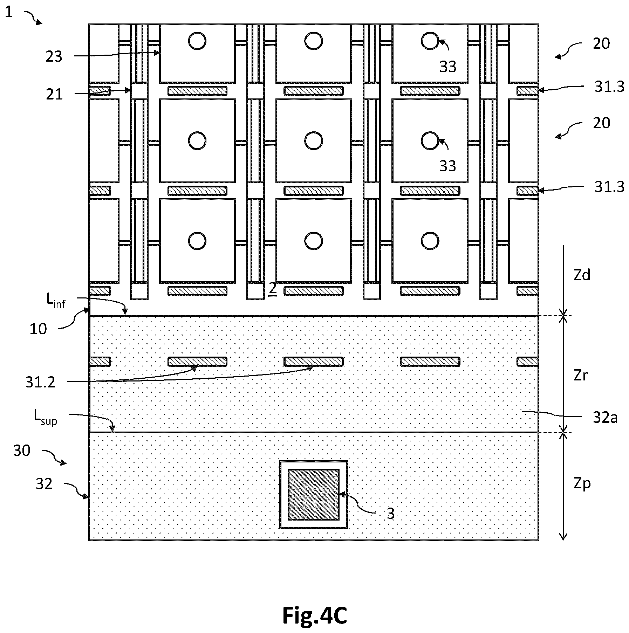

La figure 4C est une vue de dessus, schématique et partielle, du dispositif de détection 1 représenté en coupe sur la fig.4B. La portion supérieure 31.1 de la couche mince d'encapsulation 31 et la couche mince de scellement ne sont pas représentées. La zone de détection Zd s'étend jusqu'à l'extrémité inférieure L_{inf} de la face latérale 32a de la paroi périphérique 32. Elle est donc libre de toute partie de la paroi périphérique 32, et comporte la matrice de détecteurs sensibles 20. Dans cet exemple, les piliers d'appui 31.3 sont situés entre deux détecteurs sensibles 20 adjacents. Une seule ligne de piliers de renfort 31.2 est prévue dans la zone de renfort Zr et s'étend autour de la zone de détection dans le plan XY, mais plusieurs lignes parallèles peuvent être prévues. La zone périphérique Zp comporte la paroi périphérique 32 sur laquelle est en contact la portion supérieure 31.1 de la couche mince d'encapsulation 31.

Des modes de réalisation particuliers viennent d'être décrits. Différentes variantes et modifications apparaîtront à l'homme du métier.

## Revendications

1. Procédé de fabrication d'un dispositif de détection (1) d'un rayonnement électromagnétique, comportant les étapes suivantes :
o réalisation d'une matrice de détecteurs thermiques (20) adaptés à détecter le rayonnement électromagnétique, sur un substrat de lecture (10), au travers d'une première couche sacrificielle minérale (61), les détecteurs thermiques (20) et la première couche sacrificielle minérale (61) étant recouverts par une deuxième couche sacrificielle minérale (62) ;
o réalisation d'une structure d'encapsulation (30) délimitant une cavité (2) dans laquelle est située la matrice de détecteurs thermiques (20), la structure d'encapsulation (30) étant formée d'une paroi périphérique (32) et d'une couche mince d'encapsulation (31), par :
• dépôt de la couche mince d'encapsulation (31) recouvrant la deuxième couche sacrificielle minérale (62) ;
• réalisation d'évents (33) dans la couche mince d'encapsulation (31) et situés en regard de la matrice de détecteurs thermiques (20) ;
• suppression partielle des couches sacrificielles minérales (61, 62), par gravure chimique humide en milieu acide, au travers des évents (33), de manière à libérer la matrice de détecteurs thermiques (20) et à obtenir la paroi périphérique (32) formée d'une portion non gravée des couches sacrificielles minérales (61, 62), et libérer une portion supérieure (31.1) de la couche mince d'encapsulation (31) s'étendant au-dessus de la matrice de détecteurs thermiques (20) ;
o **caractérisé en ce que**, à la suite de l'étape de gravure chimique, la paroi périphérique (32) présente un retrait latéral se traduisant par un élargissement vertical de la cavité (2), dans un plan parallèle au plan du substrat de lecture, entre le substrat de lecture (10) et la portion supérieure (31.1), ce retrait latéral définissant une zone intermédiaire (Zr) d'une surface (10a) du substrat de lecture (10) entourant la matrice de détecteurs thermiques (20) ;
o le procédé comportant une étape de réalisation de piliers de renfort (31.2) de la couche mince d'encapsulation (31), agencés dans la zone intermédiaire (Zr) autour de la matrice de détecteurs thermiques (20), distincts les uns des autres et s'étendant à partir de la portion supérieure (31.1) jusqu'à reposer sur le substrat de lecture (10).

2. Procédé de fabrication selon la revendication 1, dans lequel la paroi périphérique (32) présente une face latérale (32a) délimitant latéralement la cavité (2), la face latérale (32a) s'étendant verticalement entre une extrémité inférieure (L_{inf}) au contact du substrat de lecture (10) et une extrémité supérieure (Lₛᵤₚ) au contact de la portion supérieure (31.1), l'extrémité supérieure (Lₛᵤₚ) étant distante de l'extrémité inférieure (L_{inf}), dans un plan parallèle au plan du substrat de lecture et suivant une direction opposée à la matrice de détecteurs thermiques (20), d'une distance supérieure ou égale à 10µm.

3. Procédé de fabrication selon la revendication 1 ou 2, dans lequel la portion supérieure (31.1) de la couche mince d'encapsulation (31) présente une épaisseur inférieure ou égale à 800nm.

4. Procédé de fabrication selon l'une quelconque des revendications 1 à 3, dans lequel les piliers de renfort (31.2) sont agencés en plusieurs lignes parallèles les unes aux autres, qui s'étendent autour de la matrice de détecteurs thermiques (20).

5. Procédé de fabrication selon l'une quelconque des revendications 1 à 4, dans lequel les détecteurs thermiques (20) comportent une membrane absorbante (23) suspendue au-dessus du substrat de lecture par des piliers d'ancrage (21), et dans lequel les piliers de renfort (31.2) reposent indirectement sur le substrat de lecture (10), en étant au contact de piliers inférieurs (41, 50) s'étendant à partir du substrat de lecture (10), les piliers inférieurs présentant une même hauteur que celle des piliers d'ancrage (21).

6. Procédé de fabrication selon la revendication 5, dans lequel les piliers inférieurs sont des piliers d'ancrage (41) de détecteurs dits factices (40) non adaptés à détecter le rayonnement électromagnétique, les piliers d'ancrage (41) de chaque détecteur factice (40) assurant le maintien d'une membrane suspendue (43).

7. Procédé de fabrication selon la revendication 6, dans lequel les détecteurs factices (40) présentent une structure et des dimensions identiques à celles des détecteurs thermiques (20) de la matrice.

8. Procédé de fabrication selon l'une quelconque des revendications 5 à 7, dans lequel la couche mince d'encapsulation (31) comporte des piliers d'appui (31.3), agencés en regard de la matrice de détecteurs thermiques (20), distincts les uns des autres et s'étendant à partir de la portion supérieure (31.1) jusqu'à reposer sur des piliers d'ancrage (21) des détecteurs thermiques (20), les piliers d'ancrage (21) de chaque détecteur thermique (20) assurant le maintien d'une membrane suspendue (23).

9. Procédé de fabrication selon la revendication 8, dans lequel des portions isolantes (64), réalisées en un matériau électriquement isolant, sont disposées entre et au contact des piliers d'appui (31.3) et des piliers d'ancrage (21) des détecteurs thermiques (20).

10. Procédé de fabrication selon l'une quelconque des revendications 1 à 4, dans lequel les piliers de renfort (31.2) reposent directement sur le substrat de lecture (10), en étant au contact du substrat de lecture (10).

11. Procédé de fabrication selon la revendication 10, dans lequel la couche mince d'encapsulation (31) comporte des piliers d'appui (31.3), distincts les uns des autres et s'étendant à partir de la portion supérieure (31.1) jusqu'à reposer sur et au contact du substrat de lecture (10), disposés chacun entre deux détecteurs thermiques (20) adjacents.

12. Procédé de fabrication selon la revendication 8 ou 11, dans lequel les piliers de renfort (31.2) et les piliers d'appui (31.3) présentent une structure et des dimensions identiques.

13. Procédé de fabrication selon l'une quelconque des revendications 1 à 12, dans lequel la couche mince d'encapsulation (31) comporte une portion périphérique (31.4), s'étendant continûment autour de la matrice de détecteurs thermiques (20), et disposée au-delà des piliers de renfort (31.2), dans un plan parallèle au substrat de lecture et suivant une direction opposée à la matrice de détecteurs thermiques (20), et s'étendant à partir de la portion supérieure (31.1) en direction du substrat de lecture (10) sur une partie de la hauteur de la cavité (2).

14. Procédé de fabrication selon l'une quelconque des revendications 1 à 13, dans lequel la gravure chimique humide est effectuée à l'acide fluorhydrique en phase vapeur, et les couches sacrificielles minérales (61, 62) sont réalisées en un matériau à base de silicium.

15. Dispositif de détection (1) d'un rayonnement électromagnétique, comportant :
∘ un substrat de lecture (10) ;
∘ une matrice de détecteurs thermiques (20), reposant sur le substrat de lecture (10) ;
∘ une structure d'encapsulation (30), délimitant une cavité (2) dans laquelle est située la matrice de détecteurs thermiques (20), et comportant :
• une paroi périphérique (32), réalisée en un matériau minéral, et délimitant latéralement la cavité (2) ;
• une couche mince d'encapsulation (31), comportant une portion supérieure (31.1) s'étendant au-dessus de la matrice de détecteurs thermiques (20) et reposant sur la paroi périphérique (32) ;
∘ **caractérisé en ce que** :
• la paroi périphérique (32) présente un retrait latéral se traduisant par un élargissement vertical de la cavité (2), dans un plan parallèle au substrat de lecture, entre le substrat de lecture (10) et la portion supérieure (31.1), ce retrait latéral définissant une zone intermédiaire (Zr) d'une surface (10a) du substrat de lecture (10) entourant la matrice de détecteurs thermiques (20) ;
• la couche mince d'encapsulation (31) comporte des piliers de renfort (31.2), agencés dans la zone intermédiaire (Zr) autour de la matrice de détecteurs thermiques (20), distincts les uns des autres et s'étendant à partir de la portion supérieure (31.1) jusqu'à reposer sur le substrat de lecture (10).

## Patentansprüche

1. Verfahren zum Herstellen einer Detektionsvorrichtung (1) für elektromagnetische Strahlung, das die folgenden Schritte umfasst:
∘ Erzeugen einer Anordnung aus thermischen Detektoren (20), die dazu ausgelegt sind, die elektromagnetische Strahlung auf einem Auslesesubstrat (10) durch eine erste mineralische Opferschicht (61) zu detektieren, wobei die thermischen Detektoren (20) und die erste mineralische Opferschicht (61) von einer zweiten mineralischen Opferschicht (62) bedeckt sind;
∘ Erzeugen einer Einkapselungsstruktur (30), die einen Hohlraum (2) begrenzt, in dem sich die Anordnung aus thermischen Detektoren (20) befindet, wobei die Einkapselungsstruktur (30) aus einer Umfangswand (32) und einer dünnen Einkapselungsschicht (31) gebildet wird, durch:
• Aufbringen der dünnen Einkapselungsschicht (31), die die zweite mineralische Opferschicht (62) bedeckt;
• Erzeugen von Entlüftungsöffnungen (33) in der dünnen Einkapselungsschicht (31), die sich gegenüber der Anordnung aus thermischen Detektoren (20) befinden;
• teilweises Entfernen der mineralischen Opferschichten (61, 62) durch nasschemisches Ätzen in einem sauren Medium durch die Entlüftungsöffnungen (33), um die Anordnung aus thermischen Detektoren (20) freizugeben und die Umfangswand (32) zu erhalten, die aus einem nicht geätzten Abschnitt der mineralischen Opferschichten (61, 62) gebildet wird, und einen oberen Abschnitt (31.1) der dünnen Einkapselungsschicht (31) freizugeben, die sich über der Anordnung aus thermischen Detektoren (20) erstreckt;
∘ **dadurch gekennzeichnet, dass** nach dem Schritt des chemischen Ätzens die Umfangswand (32) eine seitliche Aussparung aufweist, die zu einer vertikalen Vergrößerung des Hohlraums (2) in einer Ebene parallel zur Ebene des Auslesesubstrats zwischen dem Auslesesubstrat (10) und dem oberen Abschnitt (31.1) führt, wobei diese seitliche Aussparung einen Zwischenbereich (Zr) einer Oberfläche (10a) des Auslesesubstrats (10) definiert, der die Anordnung aus thermischen Detektoren (20) umgibt;
∘ wobei das Verfahren einen Schritt zum Erzeugen von Verstärkungssäulen (31.2) der dünnen Einkapselungsschicht (31) umfasst, die im Zwischenbereich (Zr) um die Anordnung aus thermischen Detektoren (20) herum voneinander getrennt angeordnet sind und sich vom oberen Abschnitt (31.1) aus erstrecken, bis sie auf dem Auslesesubstrat (10) aufliegen.

2. Herstellungsverfahren nach Anspruch 1, wobei die Umfangswand (32) eine Seitenfläche (32a) aufweist, die den Hohlraum (2) seitlich begrenzt, wobei sich die Seitenfläche (32a) vertikal zwischen einem unteren Ende (L_{inf}), das mit dem Auslesesubstrat (10) in Kontakt steht, und einem oberen Ende (Lₛᵤₚ), das mit dem oberen Abschnitt (31.1) in Kontakt steht, erstreckt, wobei das obere Ende (Lₛᵤₚ) vom unteren Ende (L_{inf}) in einer zur Ebene des Auslesesubstrats parallelen Ebene und in einer zur Anordnung aus thermischen Detektoren (20) entgegengesetzten Richtung um einen Abstand von größer gleich 10 µm beabstandet ist.

3. Herstellungsverfahren nach Anspruch 1 oder 2, wobei der obere Abschnitt (31.1) der dünnen Einkapselungsschicht (31) eine Dicke von kleiner gleich 800 nm aufweist.

4. Herstellungsverfahren nach einem der Ansprüche 1 bis 3, wobei die Verstärkungssäulen (31.2) in mehreren, zueinander parallelen Reihen angeordnet sind, die sich um die Anordnung aus thermischen Detektoren (20) erstrecken.

5. Herstellungsverfahren nach einem der Ansprüche 1 bis 4, wobei die thermischen Detektoren (20) eine absorbierende Membran (23) umfassen, die durch Verankerungssäulen (21) über dem Auslesesubstrat aufgehängt ist, und wobei die Verstärkungssäulen (31.2) indirekt auf dem Auslesesubstrat (10) aufliegen, indem sie mit den unteren Säulen (41, 50) in Kontakt stehen, die sich vom Auslesesubstrat (10) aus erstrecken, wobei die unteren Säulen die gleiche Höhe wie die der Verankerungssäulen (21) aufweisen.

6. Herstellungsverfahren nach Anspruch 5, wobei die unteren Säulen Verankerungssäulen (41) für sogenannte Dummy-Detektoren (40) sind, die nicht dazu ausgelegt sind, die elektromagnetische Strahlung zu detektieren, wobei die Verankerungssäulen (41) für jeden Dummy-Detektor (40) die Aufrechterhaltung einer aufgehängten Membran (43) gewährleisten.

7. Herstellungsverfahren nach Anspruch 6, wobei die Dummy-Detektoren (40) eine Struktur und Abmessungen, die mit der bzw. denen der thermischen Detektoren (20) der Anordnung identisch sind, aufweisen.

8. Herstellungsverfahren nach einem der Ansprüche 5 bis 7, wobei die dünne Einkapselungsschicht (31) Stützsäulen (31.3) umfasst, die gegenüber der Anordnung aus thermischen Detektoren (20) voneinander getrennt angeordnet sind und sich vom oberen Abschnitt (31.1) aus erstrecken, bis sie auf den Verankerungssäulen (21) der thermischen Detektoren (20) aufliegen, wobei die Verankerungssäulen (21) jedes thermischen Detektors (20) die Aufrechterhaltung einer aufgehängten Membran (43) gewährleisten.

9. Herstellungsverfahren nach Anspruch 8, wobei isolierende Abschnitte (64), die aus einem elektrisch isolierenden Material hergestellt sind, zwischen und in Kontakt mit den Stützsäulen (31.3) und den Verankerungssäulen (21) der thermischen Detektoren (20) angeordnet sind.

10. Herstellungsverfahren nach einem der Ansprüche 1 bis 4, wobei die Verstärkungssäulen (31.2) direkt auf dem Auslesesubstrat (10) aufliegen, indem sie mit dem Auslesesubstrat (10) in Kontakt stehen.

11. Herstellungsverfahren nach Anspruch 10, wobei die dünne Einkapselungsschicht (31) Stützsäulen (31.3) umfasst, die voneinander getrennt sind und sich vom oberen Abschnitt (31.3) aus erstrecken, bis sie in Kontakt mit dem Auslesesubstrat (10) auf diesem aufliegen und jeweils zwischen zwei benachbarten thermischen Detektoren (20) angeordnet sind.

12. Herstellungsverfahren nach Anspruch 8 oder 11, wobei die Verstärkungssäulen (31.2) und die Stützsäulen (31.3) eine identische Struktur und identische Abmessungen aufweisen.

13. Herstellungsverfahren nach einem der Ansprüche 1 bis 12, wobei die dünne Einkapselungsschicht (31) einen peripheren Abschnitt (31.4) umfasst, der sich kontinuierlich um die Anordnung aus thermischen Detektoren (20) erstreckt und über die Verstärkungssäulen (31.2) hinaus in einer zum Auslesesubstrat parallelen Ebene und in einer zur Anordnung aus thermischen Detektoren (20) entgegengesetzten Richtung angeordnet ist und sich vom oberen Abschnitt (31.1) aus in Richtung des Auslesesubstrats (10) über einen Teil der Höhe des Hohlraums (2) erstreckt.

14. Herstellungsverfahren nach einem der Ansprüche 1 bis 13, wobei das nasschemische Ätzen mit Flusssäure in der Dampfphase durchgeführt wird und die mineralischen Opferschichten (61, 62) aus einem Material auf Siliziumbasis hergestellt sind.

15. Detektionsvorrichtung (1) für elektromagnetische Strahlung, die Folgendes umfasst:
∘ ein Auslesesubstrat (10);
∘ eine Anordnung aus thermischen Detektoren (20), die auf dem Auslesesubstrat (10) aufliegt;
∘ eine Einkapselungsstruktur (30), die einen Hohlraum (2) begrenzt, in dem sich die Anordnung aus thermischen Detektoren (20) befindet, und die Folgendes umfasst:
• eine Umfangswand (32), die aus einem mineralischen Material hergestellt ist und den Hohlraum (2) seitlich begrenzt;
• eine dünne Einkapselungsschicht (31), die einen oberen Abschnitt (31.1) umfasst, der sich über die Anordnung aus thermischen Detektoren (20) erstreckt und auf der Umfangswand (32) aufliegt;
∘ **dadurch gekennzeichnet, dass**:
• die Umfangswand (32) eine seitliche Aussparung aufweist, die zu einer vertikalen Vergrößerung des Hohlraums (2) in einer Ebene parallel zur Ebene des Auslesesubstrats zwischen dem Auslesesubstrat (10) und dem oberen Abschnitt (31.1) führt, wobei diese seitliche Aussparung einen Zwischenbereich (Zr) einer Oberfläche (10a) des Auslesesubstrats (10) definiert, der die Anordnung aus thermischen Detektoren (20) umgibt;
• die dünne Einkapselungsschicht (31) Verstärkungssäulen (31.2) umfasst, die im Zwischenbereich (Zr) um die Anordnung aus thermischen Detektoren (20) herum voneinander getrennt angeordnet sind und sich vom oberen Abschnitt (31.1) aus erstrecken, bis sie auf dem Auslesesubstrat (10) aufliegen.

## Claims

1. Method for manufacturing a device for detecting (1) electromagnetic radiation, including the following steps of:
∘ producing an array of thermal detectors (20) adapted to detect electromagnetic radiation, on a readout substrate (10), through a first sacrificial mineral layer (61), the thermal detectors (20) and the first sacrificial mineral layer (61) being covered by a second sacrificial mineral layer (62);
∘ producing an encapsulation structure (30) delimiting a cavity (2) wherein the array of thermal detectors (20) is located, the encapsulation structure (30) being formed of a peripheral wall (32) and of an encapsulation thin layer (31), by:
• depositing the encapsulation thin layer (31) covering the second sacrificial mineral layer (62);
• producing vents (33) in the encapsulation thin layer (31) and located facing the array of thermal detectors (20);
• partially eliminating the sacrificial mineral layers (61, 62), using wet chemical acid etching, through the vents (33), so as to uncover the array of thermal detectors (20) and to obtain the peripheral wall (32) formed of a non-etched portion of the sacrificial mineral layers (61, 62), and uncover an upper portion (31.1) of the encapsulation thin layer (31) extending above the array of thermal detectors (20);
∘ **characterised in that**, following the chemical etching step, the peripheral wall (32) exhibits a lateral recess resulting a vertical enlargement of the cavity (2), in a plane parallel to the plane of the readout substrate, between the readout substrate (10) and the upper portion (31.1), this lateral recess defining an intermediate zone (Zr) of a surface (10a) of the readout substrate (10) surrounding the array of thermal detectors (20);
∘ the method including a step of producing reinforcing pillars (31.2) of the encapsulation thin layer (31), arranged in the intermediate zone (Zr) around the array of thermal detectors (20), separate from one another and extending from the upper portion (31.1) until resting on the readout substrate (10).

2. Manufacturing method according to claim 1, wherein the peripheral wall (32) has a side face (32a) laterally delimiting the cavity (2), the side face (32a) extending vertically between a lower end (L_{inf}) in contact with the readout substrate (10) and an upper end (Lₛᵤₚ) in contact with the upper portion (31.1), the upper end (Lₛᵤₚ) being at a distance from the lower end (L_{inf}), in a plane parallel to the plane of the readout substrate and in a direction opposite to the array of thermal detectors (20), by a distance greater than or equal to 10 µm.

3. Manufacturing method according to claim 1 or 2, wherein the upper portion (31.1) of the encapsulation thin layer (31) has a thickness less than or equal to 800 nm.

4. Manufacturing method according to any one of claims 1 to 3, wherein the reinforcing pillars (31.2) are arranged in a plurality of rows parallel to one another, which extend around the array of thermal detectors (20).

5. Manufacturing method according to any one of claims 1 to 4, wherein the thermal detectors (20) include an absorbent membrane (23) suspended above the readout substrate (10) by anchoring pillars (21), and wherein the reinforcing pillars (31.2) rest indirectly on the readout substrate (10), by being in contact with lower pillars (41, 50) extending from the readout substrate (10), the lower pillars (41, 50) having the same height as that of the anchoring pillars (21).

6. Manufacturing method according to claim 5, wherein the lower pillars are anchoring pillars (41) of so-called dummy detectors (40) not adapted to detect electromagnetic radiation, the anchoring pillars (41) of each dummy detector (40) ensuring the holding of a suspended membrane (43).

7. Manufacturing method according to claim 6, wherein the dummy detectors (40) have a structure and dimensions identical to those of the thermal detectors (20) of the array.

8. Manufacturing method according to any one of claims 5 to 7, wherein the encapsulation thin layer (31) includes support pillars (31.3), arranged facing the array of thermal detectors (20), separate from one another and extending from the upper portion (31.1) until resting on anchoring pillars (21) of the thermal detectors (20), the anchoring pillars (21) of each thermal detector (20) ensuring the holding of a suspended membrane (23).

9. Manufacturing method according to claim 8, wherein insulating portions (64), made of an electrically insulating material, are disposed between and in contact with the support pillars (31.3) and the anchoring pillars (21) of the thermal detectors (20).

10. Manufacturing method according to any one of claims 1 to 4, wherein the reinforcing pillars (31.2) rest directly on the readout substrate (10), by being in contact with the readout substrate (10).

11. Manufacturing method according to claim 10, wherein the encapsulation thin layer (31) includes support pillars (31.3), separate from one another and extending from the upper portion (31.1) until resting on and in contact with the readout substrate (10), each disposed between two adjacent thermal detectors (20).

12. Manufacturing method according to claim 8 or 11, wherein the reinforcing pillars (31.2) and the support pillars (31.3) have an identical structure and identical dimensions.

13. Manufacturing method according to any one of claims 1 to 12, wherein the encapsulation thin layer (31) includes a peripheral portion (31.4), extending continuously around the array of thermal detectors (20), and disposed beyond the reinforcing pillars (31.2), in a plane parallel to the readout substrate and in a direction opposite to the array of thermal detectors (20), and extending from the upper portion (31.1) in the direction of the readout substrate (10) over part of the height of the cavity (2).

14. Manufacturing method according to any one of claims 1 to 13, wherein the wet chemical etching is carried out with hydrofluoric acid in the vapor phase, and the sacrificial mineral layers (61, 62) are made of a silicon-based material.

15. A device for detecting (1) electromagnetic radiation, including:
∘ a readout substrate (10);
∘ an array of thermal detectors (20), resting on the readout substrate (10);
∘ an encapsulation structure (30), delimiting a cavity (2) wherein the array of thermal detectors (20) is located, and including:
• a peripheral wall (32), made of a mineral material, and laterally delimiting the cavity (2);
• an encapsulation thin layer (31), including an upper portion (31.1) extending above the array of thermal detectors (20) and resting on the peripheral wall (32);
∘ **characterised in that**:
• the peripheral wall (32) exhibits a lateral recess manifesting itself as a vertical enlargement of the cavity (2), in a plane parallel to the readout substrate, between the readout substrate (10) and the upper portion (31.1), this lateral recess defining an intermediate zone (Zr) of a surface (10a) of the readout substrate (10) surrounding the array of thermal detectors (20);
• the encapsulation thin layer (31) includes reinforcing pillars (31.2), arranged in the intermediate zone (Zr) around the array of thermal detectors (20), separate from one another and extending from the upper portion (31.1) until resting on the readout substrate (10).
